# EUROPEAN PATENT APPLICATION

(11) **EP 2 993 697 A1**
(43) Date of publication of application: **09.03.2016**
(21) Application number: 14194150.0
(22) Date of filing: 20.11.2014
(51) Int. Cl.: H01L 29/737, H01L 29/165, H01L 29/16, H01L 29/66

(54) **Graphene-base transistor having germanium-graphene-germanium stack**

(30) Priority: 04.09.2014 EP 14183540
(71) Applicant: IHP GmbH-Innovations for High Performance Microelectronics / Leibniz-Institut für innovative Mikroelektronik, 15236 Frankfurt / Oder (DE); Alma Mater Studiorum -Universita' di Bologna, 40126 Bologna (IT)
(72) Inventor: Gnudi, Antonio, 40126 BOLOGNA (IT); Di Lecce, Valerio, 41126 MODENA (IT); Baccarani, Giorgio, 41124 MODENA (IT); Lippert, Gunther, 15236 Frankfurt (Oder) (DE); Dabrowski, Jaroslaw, 15236 Frankfurt (Oder) (DE); Mehr, Wolfgang, 15754 Friedersdorf (DE)
(74) Representative: Eisenführ Speiser

(57) **Abstract**

A graphene-base transistor comprising a layer stack of a first Germanium layer, a base layer of graphene and a second Germanium layer, the base layer sharing a first interface with the first Germanium layer and a second interface with the second Germanium layer. By virtue of the layer stack, which comprises the graphene base layer sandwiched between the first and second Germanium layers, the graphene-base transistor of the present invention can achieve particularly high operational frequencies, in particular 3 THz and even higher.

## Description

The present invention relates of a graphene-base transistor, and to a method for making a graphene-base transistor.

The publication Lippert et al., "Graphene Grown on Ge(001) from Atomic Source", published under arXiv:1312.5425v1 [cond-mat.mes-hall] reports that Ge (001) layers on Si(001) wafers can be uniformly covered with graphene at temperatures between 800°C and the melting temperature of Ge. The deposited graphene is reported to be closed, and to have a sheet resistivity that strongly decreases with growth temperature, and weakly decreases with the amount of deposited C. Density functional theory calculations are reported which indicate that the major physical processes affecting the growth are: (1) substitution of Ge in surface dimers by C, (2) interaction between C clusters and Ge monomers, and (3) formation of chemical bonds between graphene edge and Ge (001), and that the processes (1) and (2) are surpassed by CH₂ surface diffusion when the C atoms are delivered from CH₄. The study expects that graphene can be produced directly in an active region of a transistor in a process compatible with the Si technology. According to the present invention, a graphene-base transistor is provided that comprises a layer stack of a first Germanium layer, a base layer of graphene and a second Germanium layer, the base layer sharing a first interface with the first Germanium layer and a second interface with the second Germanium layer.

By virtue of the mentioned layer stack, which comprises the graphene base layer sandwiched between the first and second Germanium layers, the graphene-base transistor of the present invention can achieve particularly high operational frequencies, in particular 3 THz and even higher. This is achieved by making use of the low effective mass of Germanium in comparison with other CMOS compatible materials such as Silicon.

At the same time, the transistor of the present invention can be fabricated on the basis of known processing technologies, since Germanium is a material that is used in industrial semiconductor process technologies such as CMOS, BiCMOS and related technologies.

The graphene-base transistor can be operated without requiring the provision of barrier layers of a different material adjacent to the base layer, in particular, without barrier layers made of an insulating material. The transistor function of the graphene-base transistor of the present invention is based on the occurrence a Schottky barrier in the layer stack at both the first and the second interfaces. The occurrence of the Schottky barriers allows differentiating switching states depending on an operating voltage applied to the three layers of the layer stack. In an OFF-state, the Schottky barriers block any charge-carrier transport between the first and second Germanium layer across the graphene base layer, and in an ON-state the Schottky barrier can be crossed by the charge carriers. A current of charge carriers within the graphene layer, i.e., parallel to the first and second interfaces, is not required nor foreseen for operating the transistor. The graphene-base transistor of the present invention thus forms a unipolar heterojunction transistor.

In the following, embodiments of the graphene-base transistor will be described.

The term "Germanium layer" is used here to encompass different embodiments. In one group of embodiments, the Germanium layer is a layer of Germanium without admixture of a further group-IV element such as silicon or carbon. In another group of embodiments, a Silicon-Germanium alloy is to be considered as forming the Germanium layer if such an alloy comprises at least 80% Germanium. In another group of embodiments, a Silicon-Germanium alloy is to be considered as forming the Germanium layer if such an alloy comprises at least 90% Germanium. In yet another group of embodiments, a Silicon-Germanium alloy is to be considered as forming the Germanium layer if such an alloy comprises at least 95% Germanium.

In some embodiments, a Silicon-Germanium alloy is used to achieve a higher maximum operation voltage. However, in considering the amount of Silicon in the Silicon-Germanium alloy, it is advantageous to achieve a high carrier mobility. In this regard, a small effective mass of the majority charge carriers is desirable. For the case of an n-type doping, a small barrier in the conduction band across the first and second interfaces is additionally desirable. In different variants of such embodiments, a Silicon fraction in the Silicon-Germanium alloy forming the Germanium layer increases with increasing distance from the interface to the graphene layer, i.e., either the first or the second interface. In some of such variants, a Silicon-Germanium alloy is present in both the first and the second Germanium layer. In other variants, only one of the first and second Germanium layers comprises a Silicon-Germanium alloy, while the other is made of Germanium.

As will be elucidated by way of different embodiments further below, the presence of a dopant in the first and second Germanium layer allows achieving a particularly high ON-state current.

Embodiments of the graphene-base transistor also achieve particularly good OFF-state properties, such as a very small or completely vanishing OFF-state current, if either the first or the second, or the first and the second Germanium layer exhibit a dopant concentration resulting in a carrier concentration of less than 10¹⁵ cm⁻³ at room temperature, corresponding substantially to an intrinsic conductivity of Germanium at the respective interface(s), and an increasing dopant concentration with increasing distance from the first and second interfaces. Using such a dopant concentration profile, in which the dopant concentration increases as a function of distance from the respective interface, the blocking effect is particularly strong in the OFF-state.

The first and second Germanium layers may assume either emitter or collector function within the layer stack. Of course, if the first Germanium layer forms the emitter, the second Germanium layer necessarily forms the collector, and vice versa. Preferably, the first Germanium layer forms an emitter layer that is either n-or p-type doped.

Accordingly, in these embodiments the second Germanium layer forms a collector layer that is n- or p-type doped, i.e., has the same conductivity type as the emitter layer. Different dopant profiles maybe used to selectively achieve certain desired transistor characteristics, depending on the desired application case.

A dopant concentration of the first Germanium layer as the emitter layer preferably has a value of between 1x10¹⁸ cm⁻³ and 1x10²⁰ cm⁻³ at the first interface. In one such embodiment, the dopant concentration value at the first interface is between 2x10¹⁸ cm⁻³ and 5x10¹⁸ cm⁻³. In another embodiment, the dopant concentration value at the first interface is between 2x10¹⁹ cm⁻³ and 5x10¹⁹ cm⁻³.

One group of embodiments has a homogeneous dopant concentration in the first Germanium layer, which forms the emitter layer, preferably with a value selected from the latter range between 2x10¹⁹ cm⁻³ and 5x10¹⁹ cm⁻³. Embodiments having such a homogenous dopant concentration throughout the emitter layer allow achieving a rather high collector current in comparison with embodiments that have a lower dopant concentration or a dopant concentration profile starting from lower concentration values at the first interface.

In a second group of embodiments, the dopant concentration in the first Germanium layer follows a dopant concentration profile, which at a distance from the first interface has a higher value than at the first interface. In some of these embodiments, a value selected from the first mentioned range between 2x10¹⁸ cm⁻³ and 5x10¹⁸ cm⁻³ forms a minimum dopant concentration within the emitter layer formed by the first Germanium layer. Different dopant concentration profile shapes can be used and form different variants within this group of embodiments. Some such variants exhibit a continuous increase of the dopant concentration in the emitter layer between the first interface up to a distance position from the first interface within the emitter layer, at which a maximum dopant concentration value is reached. This position is at an interface to an emitter contact in one of these variant, but in other variants it is at a comparatively smaller distance and thus within the emitter layer, i.e., at a distance from the emitter contact.

In some embodiments falling under the mentioned second group, which are particularly suited for achieving a high value of the transition frequency f_{T}, for instance an f_{T} of at least 3.2 THz, the dopant concentration profile in the emitter layer remains at a substantially constant value, which is assumed in the emitter layer at the first interface and in a section of the emitter layer adjacent to the first interface, but remains at this constant value only up to a certain distance from the first interface, which is smaller than the full extension of the first Germanium layer in the distance direction. The certain distance is preferably at least 3 nanometers. In one embodiment, the certain distance is at least 5 nanometers. In some embodiments the certain distance is less than 10 nanometers, for instance 8 nanometers. In sections of the emitter layer beyond the certain distance, i.e., at higher distances from the first interface, the dopant concentration preferably increases up to a value of substantially metallic conductivity, suitably to a maximum dopant concentration value between 10²⁰ cm⁻³ and 10²² cm⁻³.

Irrespective of the presence or the value of the certain distance from the first interface to the onset of the increase in the dopant concentration profile, the increase of dopant concentration is in some variants a linear increase. In another variant, the increase is non-linear, and may for instance have a line shape as a function of distance from the first interface resembling that of a root function, i.e., an exponential function with a power larger than 0 but smaller than 1, or of a saturation curve.

Irrespective of the respective shape of the dopant concentration profile across the emitter layer, the mentioned maximum dopant concentration value is preferably present at, and in some embodiments also within the emitter layer near an interface to an emitter contact.

The mentioned values, ranges and shapes of the dopant concentration apply for the case of n-type doping and for the case of p-type doping of the emitter layer formed by first Germanium layer.

The dopant concentration in the collector layer formed by the second Germanium layer is constant in some embodiments. In embodiments with a substantially homogeneous dopant concentration within the emitter layer formed by first Germanium layer, the second Germanium layer, which forms the collector layer, has a homogenous dopant concentration, which is lower than the dopant concentration of the first Germanium layer. The collector layer for instance has a dopant concentration that reaches a value of between 1x10¹⁷cm⁻³ and 6x10¹⁸ cm⁻³.

The dopant concentration of other embodiments of the graphene-base transistor is homogeneous in both the first and second Germanium layer, i.e., the dopant concentration of these embodiments does not change substantially as a function of distance from the first or second interface.

Any values of a dopant concentration mentioned herein are to be understood as net dopant concentration values.

Assuming for the sake of example the first Germanium layer to form the emitter layer, it preferably has a thickness between 5 and 50 nanometer, preferably between 10 and 50 nanometer. Even more preferably, the thickness of the first Germanium layer in an n-type graphene-base transistor is between 10 and 30 nanometer. In such embodiments of an n-type graphene-base transistor, the layer thickness of the first Germanium layer is preferably at least 5 nanometer. In a p-type graphene-base transistor, the layer thickness of the first Germanium layer is preferably between 15 and 50 nanometer. In such embodiments of a p-type graphene-base transistor, the layer thickness of the first Germanium layer is preferably at least 17 nanometer.

The Germanium layer forming the emitter layer is in some embodiments of the graphene-base transistor thinner than the Germanium layer forming the collector layer.

Assuming the second Germanium layer to form the collector layer, the second Germanium layer preferably has a thickness between more than 50, in particular 55 and 100 nanometer. In some embodiments, the second Germanium layer has a layer thickness of between 55 and 80 nanometer. In such embodiments, the layer thickness of the second Germanium layer is preferably at least 70 nanometer. This applies to embodiments of p-type and of n-type transistors.

According to a second aspect of the invention, a method for fabricating a graphene-base transistor comprises fabricating a layer stack of a first Germanium layer, a base layer of graphene and a second Germanium layer, the base layer sharing a first interface with the first Germanium layer and a second interface with the second Germanium layer.

The method shares the advantages of the graphene-base transistor of the first aspect of the invention.

In the following, embodiments of the method of the second aspect of the invention will be described.

The layer stack is preferably fabricated on a Silicon substrate.

The graphene base layer can in general be deposited on Germanium layer, which can exhibit any crystalline surface orientation. In different exemplary embodiments, the Germanium layer, on which the graphene base layer is deposited, has a (113) surface, a (001) surface, a (110) surface or a (111) surface.

In preferred embodiments, fabricating the layer stack comprises fabricating the graphene layer on the first Germanium layer and fabricating the second Germanium layer on the graphene layer.

Fabricating the graphene layer for instance comprises depositing graphene on the first Germanium layer from a vapor phase, and increasing a growth temperature during the deposition of the graphene layer.

In another embodiment, fabricating the graphene layer comprises providing a deposition of a sacrificial metal layer before the start of graphene deposition, and evaporating the metal layer during the graphene deposition.

Embodiments of the present invention are also defined by the claims.

In the following, further embodiments will be described with reference to the drawings. In the drawings:
Fig. 1 is a schematic illustration of a graphene-base transistor according to an embodiment of the present invention;
Fig. 2 is a schematic illustration of variants of the graphene-base transistor of Fig. 1 having alternative dopant concentration profiles in the first or second Germanium layer of the of Fig. 1;
Fig. 3 is a diagram showing a lower conduction-band-edge energy within a layer stack of an n-type graphene-base transistor according to the embodiment of Fig. 1 as a function of a distance from an interface between the graphene layer and the Germanium layers, plotted for embodiments having two different dopant concentration profiles across the layer stack and for different applied voltages between base and emitter, and between collector and emitter;
Fig. 4 shows three diagrams illustrating a dependence of a collector current on collector-emitter voltage in a graphene-base transistor according to different variants having differently oriented Germanium layers and a first of the two dopant concentration profiles underlying Fig. 3, plotted for different values of a base-emitter voltage;
Fig. 5 shows three diagrams illustrating a dependence of a collector current on collector-emitter voltage in graphene-base transistor according to different variants having differently oriented Germanium layers and a second of the two dopant concentration profiles underlying Fig. 3, plotted for different values of a base-emitter voltage;
Figs. 6 - 8 show three plots illustrating characteristics of variants of n-type graphene-base transistors of the present invention;
Fig. 9 is a diagram showing an upper valence-band-edge energy within a layer stack of a p-type graphene-base transistor according to the embodiment of Fig. 1 as a function of a distance from an interface between the graphene layer and the Germanium layers, plotted for embodiments having two different dopant concentration profiles across the layer stack and for different applied voltages between base and emitter, and between collector and emitter;
Fig. 10 shows two diagrams illustrating a dependence of a collector current on collector-emitter voltage in a graphene-base transistor according to different variants having two different dopant concentration profiles underlying Fig. 9, plotted for different values of a base-emitter voltage;
Figs. 11 and 12 show two plots illustrating characteristics of variants of p-type graphene-base transistors of the present invention;
Fig. 13 shows different profiles of a dopant concentration in the emitter layer according to different embodiments of the graphene-base transistor of the present invention:
Figs. 14 and 15 show plots illustrating the dependence of the collector current and of the transition frequency on the base-emitter voltage in the different embodiments indicated in Fig. 13.

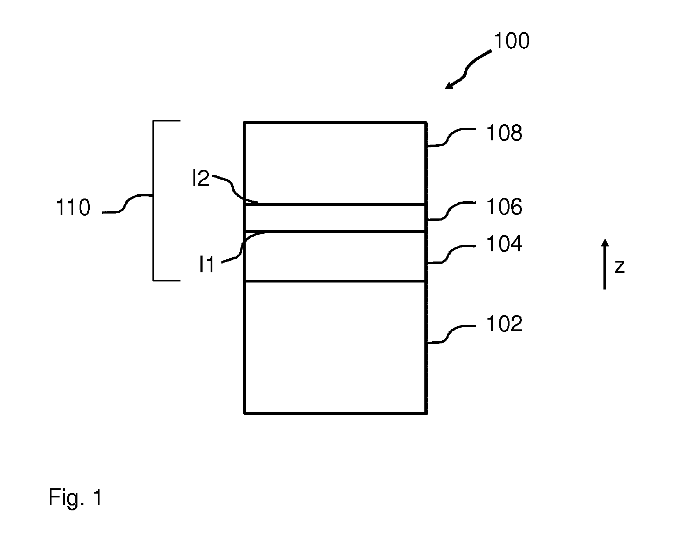

Fig. 1 is a schematic illustration of a graphene-base transistor 100 according to an embodiment of the present invention. The illustration is schematic in particular in that known features such as contact structures are omitted.

The graphene-base transistor 100 has a substrate 102, which in the present embodiment is a Silicon substrate. The use of a Silicon substrate is advantageous because this material is widely used and readily available in the form of wafers in the semiconductor industry, for instance in CMOS processing technology. In the present embodiment, the substrate is a Silicon (001) substrate. In other embodiment, which are not shown here, the substrate is Silicon-on-Insulator (SOI), a Germanium substrate, or a Germanium-on-Insulator (GeOI) substrate.

On the substrate 102, a first Germanium layer 104 is provided. The first Germanium layer 104 is for instance a Germanium (001) layer. However, other orientations may be used. In other embodiments, the first Germanium layer 104 has a (113) Germanium surface, which is equally suitable for graphene deposition, or a (110) surface, a (111) surface or any other surface which is higher-indexed than the ones mentioned.

On the first Germanium layer 104, a graphene layer 106 is arranged. The first Germanium layer 104 and the graphene layer 106 share a first interface I1. In other words, the graphene layer 104 is directly arranged on the first Germanium layer without any interposed layer of different material.

On the graphene layer 106, a second Germanium layer 108 is arranged. The second Germanium layer 108 and the graphene layer share a common interface I2 with each other. Again, this means that no interposed other material layer is arranged between the graphene layer 106 and the second Germanium layer 108.

The sequence of the first Germanium layer 104, the graphene layer 106 and the second Germanium layer 108 is a layer stack 110 which with respect to the operation of the graphene-base transistor 100 forms an active-layer stack. In other words, the layer stack 110 determines operational characteristics of the graphene-base transistor 100. In the graphene-base transistor 100 of Fig. 1, the first Germanium layer 104 forms an emitter, the graphene layer 106 forms a base, and the second Germanium layer 108 forms a collector. It is noted that other embodiments, which are not shown here, use an opposite order of layers in the layer stack 110, i.e., have the collector directly adjacent to the substrate 102, followed by the base and the emitter.

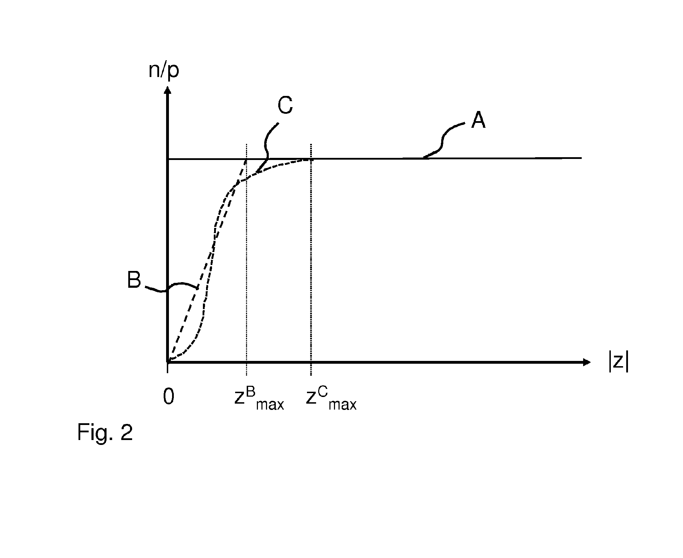

The operational characteristics of a transistor with the layer structure shown in Fig. 1 will in the following be explained by way of various embodiments with reference to the Figs. 2 to 12.

The operational characteristics depend on a dopant concentration profile in the first and second Germanium layers 104 and 108. With reference to Fig. 2, different alternative dopant concentration profiles A, B and C are shown in a schematic graphical representation. The diagram of Fig. 2 is representative for embodiments of n-type graphene-base transistors as well as p-type graphene-base transistors. This is indicated by the notation "n/p" at the ordinate of the diagram of Fig. 2. The ordinate forms a linear scale in arbitrary units of the dopant concentration, which can be expressed by the number of dopant atoms per cm³. On the abscissa, a distance amount |z| from the interface I1 or I2 to the graphene layer is shown on a linear scale in arbitrary units.

The dopant profile A is a constant dopant concentration throughout the respective Germanium layer, which may be either the first Germanium layer 104 or the second Germanium layer 108 or both Germanium layers 104 and 108. However, the concentration value is typically not the same in the first and second Germanium layers 104 and 108. The concentration value is for example in the range between 1x10¹⁸ cm⁻³ and 6x10¹⁹ cm⁻³ for the case in which the Germanium layer forms the emitter. In the embodiment of Fig. 1, this applies to the first Germanium layer 104. In case the Germanium layer forms the collector, the dopant concentration of the Germanium layer is for example between 1x10¹⁷ cm⁻³ and 5x10¹⁸ cm⁻³. In the embodiment of Fig. 1, this applies to the second Germanium layer 108. As mentioned, the order of emitter, base and collector can be reversed.

The dopant concentration profile B exhibits a linear increase of the dopant concentration starting from the interface between the respective Germanium layer and the graphene layer.

In this dopant concentration profile B, the dopant concentration at the interface (|z|=0) is less than 10¹⁵ cm⁻³ at room temperature. This substantially corresponds to an intrinsic conductivity of Germanium. The maximum dopant concentration of the dopant concentration profile B is equal to that of the dopant concentration profile A, and may assume any value in the intervals mentioned above, depending on the function of the given Germanium layer in the layer stack 110, as discussed.

The dopant concentration profile C is similar to the dopant concentration profile B. However, the curve of the concentration profile C exhibits a wider range of low dopant concentration and approaches the maximum value corresponding to that of the dopant concentration profile A and B in a line-shape similar to that of a saturation behavior. The dopant concentration profile C is typical for a diffusion or implantation process.

An advantage of the dopant concentration profiles B and C is a reduction of the OFF-state current.

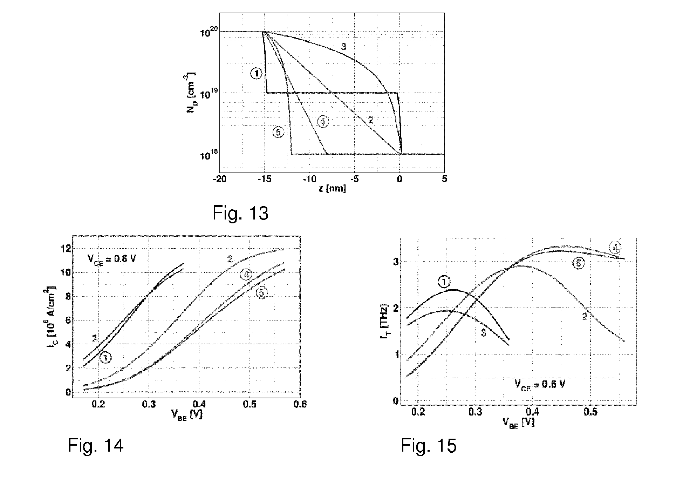

Further examples of dopant concentration profiles will be described further below with reference to Fig. 13.

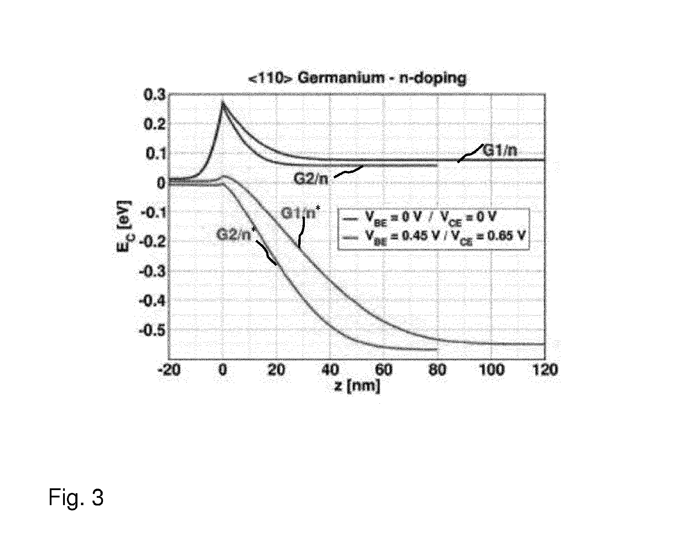

Fig. 3 is a diagram showing a lower conduction-band-edge energy within a layer stack of an n-type graphene-base transistor according to the embodiment of Fig. 1 as a function of a distance from an interface between the graphene layer and the Germanium layers, plotted for embodiments having two different dopant concentration profiles across the layer stack and for different applied voltages between base and emitter, and between collector and emitter. Negative z values correspond to positions in the emitter, i.e. the first Germanium layer 104. Positive z values correspond to positions in the collector, i.e., the second Germanium layer 108. The graphene layer does not show directly in Fig. 3, but is present as a monoatomic layer at z= 0.

The individual plots are labeled G1/n, G2/n, and G1/n*, G2/n*. This notation indicates OFF-state (G1/n, G2/n) and ON-state (G1/n* G2/n*) plots of the lower-conduction-band edge for two different embodiments of n-type graphene-base transistors. The plots were calculated based on the following assumptions:
a) The graphene layer 106 is undoped.
b) The maximum amount of the collector-emitter voltage is 0.65 V. This limitation is chosen to avoid the risk of impact ionization.
c) The Dirac point is 0.55 eV below the conduction band edge.
d) Ballistic transport and a zero base current are assumed.
e) The dopant distribution within the emitter and collector layers is assumed to be homogeneous, corresponding to the dopant concentration profile A shown in Fig. 3.
f) For the OFF-state calculation, both the base-emitter voltage and the collector-emitter voltage are set to 0 V.
g) For the ON-state calculation, the base-emitter voltage is set to a value of 0.45 V, and the collector-emitter voltage is set to a value of 0.65 V.

The simulation model is based on a full quantum transport approach, with an effective mass Hamiltonian. All conduction band valleys are taken into account. Ballistic transport is assumed, all scattering mechanisms being neglected. The graphene layer 106 is considered transparent to impinging electrons. The transport model is solved self-consistently with the Poisson equation, which provides the electric potential. On the graphene layer 106 a sheet charge density is included in Poisson equation according to the Dirac graphene density-of-states and the equilibrium energy distribution of electrons and holes with Fermi level equal to the base voltage.

The dopant profile of the embodiment underlying the plot G1/n has an emitter donor concentration of 5x10¹⁸ cm⁻³ and a collector donor concentration of 5x10¹⁷ cm⁻³. In the following, also the corresponding embodiment will be referred to as G1/n.

The dopant concentration profile of the embodiment underlying the plot G2/n has an emitter donor concentration of 5x10¹⁸ cm⁻³ as the embodiment G1/n, but a collector donor concentration of 1x10¹⁸ cm⁻³. In the following, also the corresponding embodiment will be referred to as G2/n.

As can be seen from the OFF-state plots G1/n and G2/n in Fig. 3, the layer stack 110 achieves a potential barrier in the lower conduction-band edge around z=0, that is, in a transitional region between the emitter 108, the graphene layer 106 and the collector 104.

The potential barrier reaches almost 0.3 eV. It has the same height in both embodiments G1/n and G2/n, but has a larger extension in z-direction in the embodiment G1n that has the lower collector dopant concentration.

The following approximate minimum-thickness values are inferred from Fig. 3, based on the requirement that the emitter and collector layers should at least accommodate space charge regions occurring in the transitional region: the minimum thickness of the emitter layer for both embodiments G1/n and G2/n is 12 nanometer. The minimum thickness of the collector layer is 100 nanometer for the embodiment G1/n and 70 nanometer for the embodiment G2/n.

As the curves G1/n* and G2/n* for the ON-state in Fig. 3 show, the potential barrier at the conduction band edge vanishes upon application of suitable operational voltages in both embodiments G1/n and G2/n, thus proving transistor functionality.

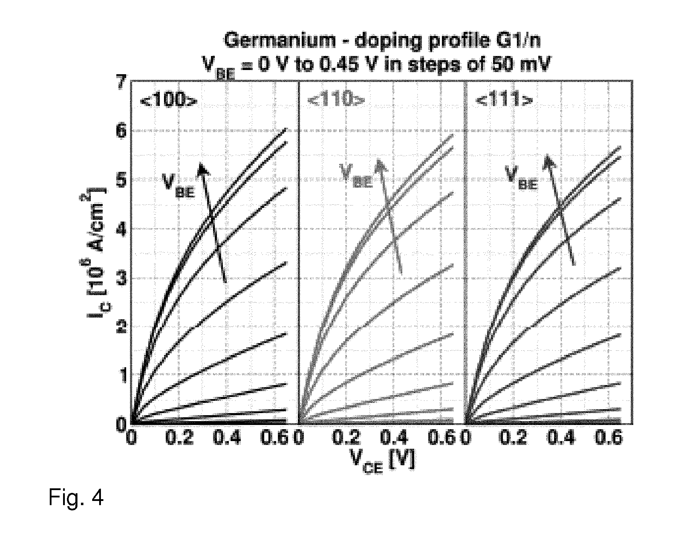

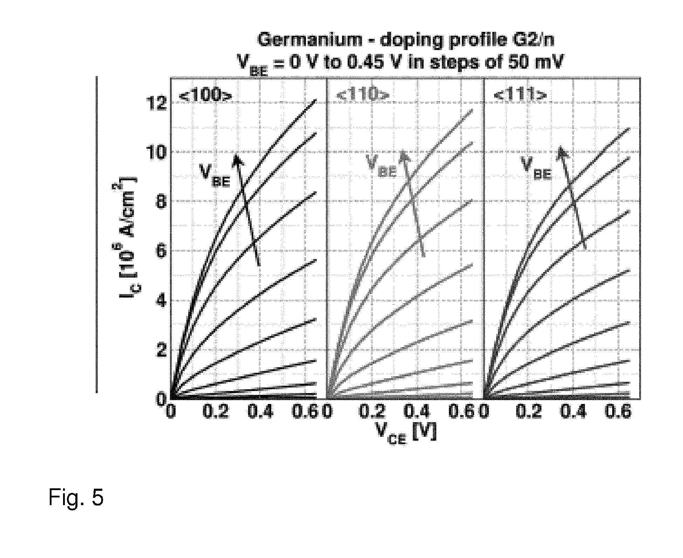

The calculations performed by the inventors for different embodiments having different crystalline orientations of the Germanium layers 104 and 108 also show that there is no substantial dependence of the result on the crystalline orientation. This will also be shown in the Figs. 4 and 5 described in the following.

In the following, reference is made in parallel to Figs. 4 and 5. Fig. 4 shows three diagrams illustrating a dependence of a collector current on collector-emitter voltage in a graphene-base transistor according to different variants having differently oriented Germanium layers in the embodiment G1/n of Fig. 3, plotted for different values of a base-emitter voltage. Similarly, Fig. 5 shows three diagrams illustrating a dependence of a collector current on collector-emitter voltage in graphene-base transistor according to different variants having differently oriented Germanium layers in the embodiment G2/n of Fig. 3, plotted for different values of a base-emitter voltage. The curves for both embodiments show typical transistor output characteristics of the collector current as a function of the collector-emitter voltage. As can be seen, the crystal orientation in Germanium does not significantly effect the output characteristics of the graphene-base transistor.

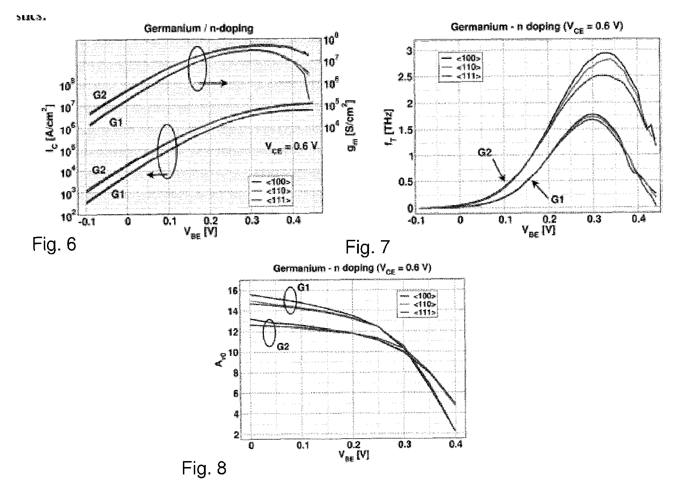

Figs. 6 to 8 show different characteristics of embodiments of graphene-base transistors according to different variants of the embodiments G1/n and G2/n of the present invention. Fig. 6 shows the turn-on characteristics, while Figs. 7 and 8 show cut-off frequency and intrinsic voltage gain. As can be seen, good transistor characteristics are achieved. In particular, a high transition frequency f_{T} is achieved, due to a higher collector dopant concentration.

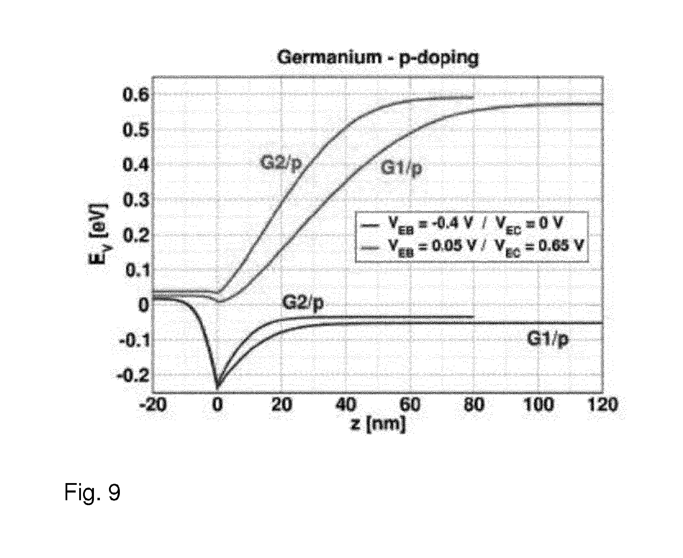

In the following, embodiments of p-type graphene-base transistors will be discussed. Fig. 9 is a diagram showing an upper valence-band-edge energy within a layer stack of a p-type graphene-base transistor according to the embodiment of Fig. 1 as a function of a distance from an interface between the graphene layer and the Germanium layers, plotted for embodiments G1/p and G2/p having two different dopant concentration profiles across the layer stack and for different applied voltages between base and emitter, and between collector and emitter. Again, negative z values correspond to positions in the emitter, i.e. the first Germanium layer 104. Positive z values correspond to positions in the collector, i.e., the second Germanium layer 108.

The labeling corresponds to that explained in the context of Fig. 3.

The plots were calculated using the same model and assumptions underlying the calculations performed for the plots of Fig. 3. Both light and heavy holes are considered.

The dopant profile of the embodiment underlying the plot G1/p has an emitter acceptor concentration of 5x10¹⁸ cm⁻³ and a collector acceptor concentration of 5x10¹⁷ cm⁻³. In the following, also the corresponding embodiment will be referred to as G1/p.

The dopant concentration profile of the embodiment underlying the plot G2/p has an emitter acceptor concentration of 5x10¹⁸ cm⁻³ as the embodiment G1/p, but a collector acceptor concentration of 1x10¹⁸ cm⁻³. In the following, also the corresponding embodiment will be referred to as G2/p.

As can be seen from the OFF-state plots G1/n and G2/n in Fig. 3, the layer stack 110 achieves a potential barrier in the upper valence-band edge around z=0, that is, in a transitional region between the emitter 108, the graphene layer 106 and the collector 104.

The potential barrier reaches a value of more than -0.2 eV. It has the same height in both embodiments G1/p and G2/p, but has a larger extension in z-direction in the embodiment G1/p that has the lower collector dopant concentration.

The following approximate minimum-thickness values are inferred from Fig. 9, based on the requirement that the emitter and collector layers should at least accommodate space charge regions occurring in the transitional region: the minimum thickness of the emitter layer for both embodiments G1/p and G2/p is 17 nanometer. The minimum thickness of the collector layer is 100 nanometer for the embodiment G1/p and 70 nanometer for the embodiment G2/p.

As the curves G1/p and G2/p for the ON-state in Fig. 9 show, the potential barrier at the conduction band edge vanishes upon application of suitable operational voltages in both embodiments G1/p and G2/p, thus proving transistor functionality.

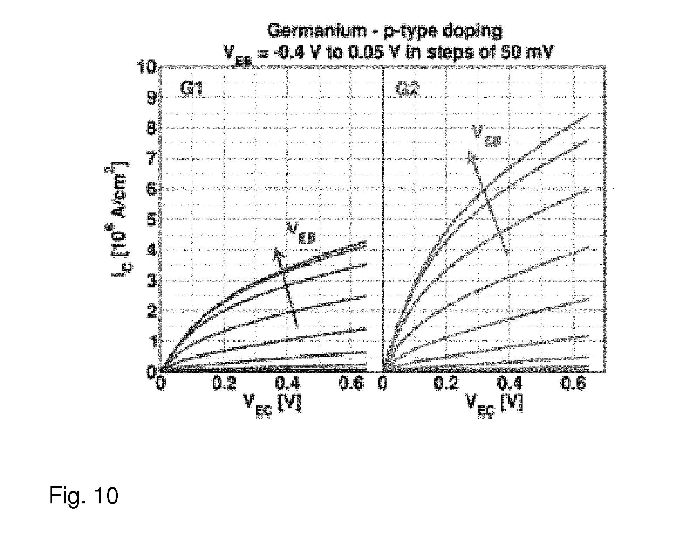

Fig. 10 shows two diagrams illustrating a dependence of a collector current on emitter-collector voltage in a graphene-base transistor according to the embodiments G1/p and G2/p underlying Fig. 9, plotted for different values of a emitter-base voltage. The curves for both embodiments show typical transistor output characteristics of the collector current as a function of the emitter-collector voltage.

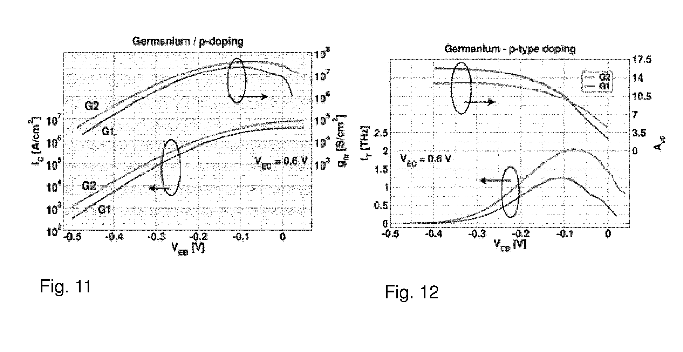

Figs. 11 and 12 show characteristics of the embodiments G1/p and G2/p of a p-type graphene-base transistor.

Fig. 13 shows different profiles of a dopant concentration in the emitter layer according to different embodiments of the graphene-base transistor of the present invention.

In addition to profile 1 (constant value and abrupt change of dopant concentration at the interfaces), linear (profiles 3 and 5) or exponential (profiles 2 and 4) dopant concentration profiles form different embodiments. The graphene sheet is always located at z = 0. Profiles 1, 4, and 5 have the same implanted dopant dose (ions/cm²).

As is visible in all embodiments, the dopant concentration is kept very high at the interface to the emitter contact, i.e., at a distance of 10 nm to the graphene layer (N_{E} = 3x10²⁰ cm⁻³). Between this highly doped region and the graphene base there is a 10 nm layer (the first Germanium layer mentioned in the claims), which has one of the dopant concentration profiles labeled 1 to 5. Such structure is intended to favor ohmic coupling with the contact.

Figs. 14 and 15 show plots illustrating the dependence of the collector current and of the transition frequency on the base-emitter voltage in the different embodiments indicated in Fig. 13. Not only the functionality of the GBHT is preserved with non-uniform emitter doping profiles, but the performance can be increased by keeping the emitter region towards graphene less doped: this helps shifting the characteristics towards higher V_{BE} values, too.

## Claims

1. A graphene-base transistor comprising a layer stack of a first Germanium layer, a base layer of graphene and a second Germanium layer, the base layer sharing a first interface with the first Germanium layer and a second interface with the second Germanium layer.

2. The transistor of claim 1, wherein the first Germanium layer forms an emitter layer, which has a dopant concentration between 2x10¹⁸ cm³ and 5x10¹⁸ cm⁻³ at the first interface.

3. The transistor of claim 1 or 2, wherein the dopant concentration in the first Germanium layer follows a dopant concentration profile, which at a distance from the first interface has a higher value than at the first interface.

4. The transistor of claim 1, wherein the first Germanium layer forms an emitter layer, which has a homogeneous dopant concentration of a value between 2x10¹⁹ cm⁻³ and 5x10¹⁹ cm⁻³.

5. The transistor of at least one of the claims 1 to 3, wherein the second Germanium layer forms a collector layer that has a homogenous dopant concentration, which is equal to the dopant concentration of the first Germanium layer at the first interface..

6. The transistor of claim 4, wherein the second Germanium layer forms a collector layer that has a homogenous dopant concentration, which is lower than the dopant concentration of the first Germanium layer.

7. The transistor of at least one of the precedent claims, wherein a dopant concentration of the second Germanium layer is between 1x10¹⁷cm⁻³ and 6x10¹⁸cm⁻³.

8. The transistor at least one of the precedent claims, wherein the first Germanium layer has a thickness of between 10 and 20 nanometer.

9. The transistor of at least one of the precedent claims, wherein the second Germanium layer has a thickness between 50 and 100 nanometer.

10. A method for fabricating a graphene-base transistor comprising fabricating a layer stack of a first Germanium layer, a base layer of graphene and a second Germanium layer, the base layer sharing a first interface with the first Germanium layer and a second interface with the second Germanium layer.

11. The method of claim 10, comprising fabricating the layer stack on a Silicon substrate.

12. The method of claim 10 or 11, wherein fabricating the layer stack comprises fabricating the graphene layer on the first Germanium layer and fabricating the second Germanium layer on the graphene layer.

13. The method of claim 12, wherein fabricating the graphene layer comprises depositing graphene on the first Germanium layer from a vapor phase, and wherein a growth temperature is increased during depositing the graphene.

14. The method of claim 12 or 13, wherein fabricating the graphene layer comprises providing a deposition of a sacrificial metal layer before the start of graphene deposition, and evaporating the metal layer during the graphene deposition.
